# EUROPÄISCHE PATENTSCHRIFT

(11) **EP 4 178 754 B1**
(45) Veröffentlichungstag und Bekanntmachung des Hinweises auf die Patenterteilung: **20.08.2025**
(21) Anmeldenummer: 21743136.0
(22) Anmeldetag: 08.07.2021
(51) Int. Cl.: B23K 26/00, B23K 26/0622, B23K 26/06, B23K 26/067, B23K 26/352, B23K 26/364, B23K 26/402, H01L 21/027

(54) **VERFAHREN ZUR STRUKTURIERUNG EINER STRUKTURSCHICHT MITTELS LASERSTRAHLUNG**
METHOD FOR STRUCTURING A STRUCTURAL LAYER BY MEANS OF LASER RADIATION
PROCÉDÉ POUR FORMER DES MOTIFS SUR UNE COUCHE DE STRUCTURE PAR RAYONNEMENT LASER

(30) Priorität: 08.07.2020 DE 102020118019
(43) Veröffentlichungstag der Anmeldung: 17.05.2023
(73) Patentinhaber: Fraunhofer-Gesellschaft zur Förderung der angewandten Forschung e.V., 80686 München (DE)
(72) Erfinder: MEYER, Fabian, 79110 Freiburg (DE); BRAND, Andreas, 79110 Freiburg (DE); NEKARDA, Jan, 79110 Freiburg (DE)
(74) Vertreter: LBP Lemcke, Brommer & Partner Patentanwälte mbB
(86) Internationale Anmeldenummer: PCT/EP2021/068978
(87) Internationale Veröffentlichungsnummer: WO 2022/008650

(56) Entgegenhaltungen:
- DE-A1- 102007 006 640
- JP-A- 2017 060 991
- JP-B2- 5 103 054
- US-A1- 2018 257 174

## Beschreibung

Die Erfindung betrifft ein Verfahren zur Strukturierung einer Strukturschicht mittels Laserstrahlung.

Es ist bekannt, eine Strukturschicht mittels Laserstrahlung zu bearbeiten, um Teile der Strukturschicht zu entfernen und so eine vorgegebene Struktur zu erzielen, welche an sich Gegenstand eines Bauelementes sein kann oder als Maske für eine weitere Bearbeitung dient. So ist es bei der Herstellung und Bearbeitung von Halbleiterbauelementen bekannt, eine Strukturschicht mittels Laserstrahlung zu strukturieren, insbesondere bei der Herstellung von großflächigen Halbleiterbauelementen wie beispielsweise photovoltaischen Solarzellen oder OLEDs.

Hierbei wird eine Schichtstruktur mit zumindest einer Trägerschicht und zumindest einer auf der Trägerschicht angeordneten Strukturschicht bereitgestellt. Durch Beaufschlagen der Schichtstruktur mittels Laserstrahlung wird die Strukturschicht in Teilbereichen entfernt, um eine gewünschte Struktur auszubilden. Ein solches Verfahren, bei welchem zusätzlich ein Lift-off einer Materialschicht erfolgt, ist aus DE 10 2007 006 640 A1 bekannt.

Bei vielfältigen Herstellungsverfahren, insbesondere bei Halbleiterbauelementen und hier insbesondere bei photovoltaischen Solarzellen ist die Strukturierung der Strukturschicht mit möglichst dünnen Linien, insbesondere geradlinigen Linien, wünschenswert. Eine solche Strukturierung ist zwar grundsätzlich mittels zusätzlicher Maskierungsschritte unter Verwendung von Fotolithografie möglich. Solche Verfahren erfordern jedoch einen hohen apparativen Aufwand und sind daher sehr kostenaufwendig. Weitere Verfahren zur Strukturierung einer Strukturschicht sind bekannt aus JP 2017 060991 A (offenbarend den Oberbegriff des Anspruchs 1), US 2018/257174 A1 oder JP 5 103054 B2.

Es besteht daher ein Bedarf, bekannte Verfahren, bei welchen eine Strukturschicht mittels Laserstrahlung strukturiert wird, zu verbessern, sodass dünnere Linien und/oder Linien mit geringerer Schädigung der Trägerschicht in der Strukturschicht erzeugt werden können.

Gelöst ist diese Aufgabe durch ein Verfahren gemäß Anspruch 1. Vorteilhafte Ausgestaltungen des Verfahrens finden sich in den abhängigen Ansprüchen.

Das erfindungsgemäße Verfahren zur Strukturierung einer Strukturschicht mittels Laserstrahlung weist folgende Verfahrensschritte auf:
In einem Verfahrensschritt A erfolgt ein Bereitstellen einer Schichtstruktur mit zumindest einer Trägerschicht und zumindest einer auf der Trägerschicht angeordneten Strukturschicht. In einem Verfahrensschritt B erfolgt ein Beaufschlagen der Schichtstruktur mittels Laserstrahlung, um die Strukturschicht in Teilbereichen zu entfernen.

Wesentlich ist, in einem Teilschritt B1 ein Beaufschlagen der Schichtstruktur mittels Laserstrahlung in einem ersten Bearbeitungsbereich B1 mit einer ersten Fluenz Φ_{L1} der Laserstrahlung erfolgt, sodass in dem mittels Laserstrahlung beaufschlagten ersten Bearbeitungsbereich B1 eine Schwellfluenz Φ_{S} des Schichtsystems zur Ablation der Strukturschicht auf eine verringerte Schwellfluenz Φ_{B1} < Φ_{S} abgesenkt wird, wobei die erste Fluenz Φ_{L1} unterhalb der Schwellfluenz Φ_{S} des Schichtsystems liegt. In einem Teilschritt B2 erfolgt ein Beaufschlagen der Schichtstruktur mittels Laserstrahlung in einem zweiten Bearbeitungsbereich B2 mit einer zweiten Fluenz Φ_{L2}, wobei die zweite Fluenz Φ_{L2} größer als die verringerte Schwellfluenz Φ_{B1} des ersten Bearbeitungsbereiches und kleiner als die Schwellfluenz Φ_{S} ist. Der zweite Bearbeitungsbereich B2 überdeckt nur einen Teilbereich des ersten Bearbeitungsbereiches B1. Die anfängliche Schwellfluenz Φ_{S} des Schichtsystems wird somit in Schritt B1 mittels Laserstrahlung verringert auf die Schwellfluenz Φ_{B1}.

Die vorliegende Erfindung beruht auf der Erkenntnis, dass bei den aus dem Stand der Technik bekannten Verfahren einerseits eine Ausbildung dünner Linien eine exakte und hohe Fokussierung eines Laserstrahls erfordert. Hierdurch ergibt sich eine hohe Anforderung an die Präzision und Wiederholgenauigkeit der für den Laserstrahl verwendeten Optik, sodass im Ergebnis die Bearbeitungskosten steigen. Andererseits wird bei den Verfahren gemäß Stand der Technik stets eine Laserfluenz größer der Schwellfluenz des Schichtsystems zur Ablation der Strukturschicht verwendet, sodass unmittelbar durch Einwirkung einer Beaufschlagung mit Laserstrahlung eine zumindest teilweise Ablation der Strukturschicht erfolgt. Hierdurch besteht jedoch ein erhebliches Risiko, die Schichtstruktur im Bearbeitungsbereich zu schädigen, insbesondere die Trägerschicht zu schädigen. Dies ist besonders relevant, wenn das Verfahren zur Bearbeitung von Halbleiterstrukturen verwendet wird und insbesondere, wenn die Trägerschicht eine Halbleiterschicht, insbesondere eine Siliziumschicht ist.

Bei bisherigen Verfahren wurden somit mittels Laserpulsen Öffnungen in der Strukturschicht erzeugt und die Öffnungen entsprechend aneinandergereiht, um eine gewünschte Form der Öffnung, insbesondere eine Linie, zu erzeugen. Hierzu weist die Schichtstruktur abhängig von Materialparametern, insbesondere den verwendeten Materialien und den Schichtdicken der Schichten der Schichtstruktur, eine spezifische Schwellfluenz auf, ab welcher eine Beaufschlagung mit Laserstrahlung zu einer Ablation der Strukturschicht führt. Die Schwellfluenz Φ_{S} des Schichtsystems zur Ablation der Strukturschicht kann somit für jedes Schichtsystem in einfacher Weise ermittelt werden, indem ausgehend von einer niedrigen Fluenz die Fluenz der Laserstrahlung erhöht wird, bis eine Ablation der Strukturschicht erfolgt. Darüber hinaus sind auch Untersuchungen zur Schwellfluenz bekannt, wie beispielsweise in J. Bonse, et al. "Femtosecond laser ablation of silicon-modification thresholds and morphology", Appl. Phys. A, Bd. 74, Nr. 1, S. 19 - 25, JAM.2002.

Die vorliegende Erfindung nutzt nun die Erkenntnis, dass auch bei Beaufschlagen der Schichtstruktur unterhalb der Schwellfluenz Φ_{S} des Schichtsystems zur Ablation der Strukturschicht zwar keine Ablation der Strukturschicht erfolgt, jedoch eine Veränderung der Schichtstruktur, insbesondere eine Absenkung der Schwellfluenz Φ_{B1} in dem in Teilschritt B1 mittels Laserstrahlung der Fluenz Φ_{L1} beaufschlagten Bearbeitungsbereich B1. Durch Teilschritt B1 wird somit in der Schichtstruktur im Bearbeitungsbereich B1 eine geringere Schwellfluenz Φ_{B1} erzeugt, verglichen mit der Schwellfluenz Φ_{S} in den nicht bearbeiteten Bereichen der Schichtstruktur.

In Teilschritt B2 erfolgt ein Beaufschlagen der Schichtstruktur mittels Laserstrahlung in einem zweiten Bearbeitungsbereich B2 mit einer zweiten Fluenz Φ_{L2}, wobei die zweite Fluenz Φ_{L2} ebenfalls kleiner als die Schwellfluenz Φ_{S} ist. Hierdurch erfolgt in den Bereichen, welche nicht in Teilschritt B1 mittels Laserstrahlung der Fluenz Φ_{L1} beaufschlagt wurden, keine Ablation, da die zweite Fluenz Φ_{L2} der Laserstrahlung in Teilschritt B2 kleiner als die Schwellfluenz Φ_{S} ist. In den Bereichen, in welchen der Bearbeitungsbereich B2 mit dem Bearbeitungsbereich B1 überlappt, erfolgt jedoch eine Ablation der Strukturschicht, da die zweite Fluenz Φ_{L2} der Laserstrahlung in Teilschritt B2 größer als die Schwellfluenz Φ_{B1} im ersten Bearbeitungsbereich B1 ist.

Da der zweite Bearbeitungsbereich nur einen Teilbereich des ersten Bearbeitungsbereiches B1 überdeckt, erfolgt die Ablation der Strukturschicht in Teilschritt B2 in einem Bereich, welcher kleiner als der Bearbeitungsbereich B1 und auch kleiner als der Bearbeitungsbereich B2 ist und in etwa der Schnittmenge zwischen den Bearbeitungsbereichen B1 und B2 entspricht, das heißt denjenigem Bereich, in welchem Bearbeitungsbereich B2 mit dem Bearbeitungsbereich B1 überlappt.

Ein weiterer Vorteil ist, dass bei einer gegebenen Numerischen Apertur eines optischen Abbildungssystems für die Laserstrahlung kleinere Strukturgrößen erreicht werden können als bei vorbekannten Verfahren oder für eine gegebene Strukturgröße eine geringere Numerische Apertur gewählt werden kann, so dass typischerweise eine kürzere Bearbeitungszeit ermöglicht wird.

Vorteilhafterweise erfolgt in Teilschritt B1 ein Beaufschlagen der Schichtstruktur mittels Laserstrahlung der ersten Fluenz Φ_{L1}, welche größer als eine Inkubationsfluenz Φ_{I} der Schichtstruktur ist. Die Inkubationsfluenz Φ_{I} stellt eine Untergrenze für die Laserfluenz dar, ab welcher signifikant eine Veränderung der Schwellfluenz der Schichtstruktur in dem mit Laserstrahlung beaufschlagten ersten Bearbeitungsbereich B1 erfolgt. Auch die Inkubationsfluenz Φ_{I} hängt von Materialparametern der Schichtstruktur, insbesondere der Schichtmaterialien sowie der Dicke der einzelnen Schichten ab und kann in einer einfachen Versuchsreihe bestimmt werden, indem ausgehend von einer niedrigen Laserfluenz die Laserfluenz erhöht wird und stets geprüft wird, ob eine Änderung der Schwellfluenz erzielt wurde. Eine Änderung der Schwellfluenz kann typischerweise bereits optisch detektiert werden. Darüber hinaus sind Techniken zur Bestimmung solcher Grenzfluenzen bekannt und beispielsweise in J. M. Liu "Simple technique for measurements of pulsed Gaussian-beam spot sizes", Optics Letters, Vol. 7, No. 5, May 1982 beschrieben:

Liu beschreibt das Verfahren zur Bestimmung zweier Schwellfluenzen, die zweier Modifikationen entsprechen, in diesem Fall dem Ausbilden einer vorgeschädigten Zone (Φ_{I} ) und der Ablation einer daraufliegenden Schicht (Φ_{S}), wobei Φ_{I} <Φ_{S}. Es wird hiermit vorgeschlagen, wie dieses Verfahren zur Bestimmung der Schwellfluenz Φ_{B1} erweitert werden kann: zunächst wird mit dem Verfahren nach Liu, die Schwellfluenzen Φ_{I} und Φ_{S} für das vorliegende Substrat bestimmt. Nun wird eine Fluenz Φ₀ gewählt, sodass Φ_{I} < Φ₀ < Φ_{B1}. Mit dieser Fluenz werden räumlich separierte Stellen mit jeweils einem Puls beaufschlagt. In einem zweiten Schritt werden nun dieselben Stellen mit aufsteigender Fluenz beaufschlagt. Analog zu der Methode von Liu, lässt sich dann durch Extrapolation der geöffneten Fläche auf 0, die Schwellfluenz Φ_{B1} für die Ablation auf einem vorgeschädigten Substrat bestimmen.

Das erfindungsgemäße Verfahren weist den Vorteil auf, dass lediglich im Überlappungsbereich der Bearbeitungsbereiche B1 und B2 eine Ablation der Strukturschicht erfolgt. Hierdurch können Strukturen mit genauem Ausmaß, insbesondere dünne Linien mit einer Linienbreite kleiner des Durchmessers des Laserstrahls im Bearbeitungsbereich ausgebildet werden, es ist somit verglichen mit den aus dem Stand der Technik bekannten Verfahren eine geringere Fokussierung notwendig bzw. die Strukturgröße kann bei gleichbleibender Fokussierung verkleinert werden.

Darüber hinaus wird in den Verfahrensschritten B1 und B2 jeweils Laserstrahlung mit einer Fluenz kleiner der Schwellfluenz Φ_{S} verwendet. Hierdurch entsteht gegenüber den aus dem Stand der Technik bekannten Verfahren ein geringerer maximaler Energieeintrag in die Schichtstruktur und somit besteht ein geringeres Risiko einer Schädigung insbesondere der Trägerschicht.

Vorteilhafterweise überdeckt der zweite Bearbeitungsbereich B2 weniger als 50 %, insbesondere weniger als 20 % der Fläche des ersten Bearbeitungsbereiches B1. Hierdurch wird die zuvor beschriebene Verringerung der Schichtstruktur erzielt, ohne dass eine Erhöhung der Fokussierung des Laserstrahls notwendig ist. Insbesondere ist es vorteilhaft, dass der zweite Bearbeitungsbereich B2 im Bereich 1 % bis 50 %, insbesondere 5 % bis 20 % der Fläche des ersten Bearbeitungsbereiches B1 überdeckt.

In einer vorteilhaften Ausgestaltung weist die Strukturschicht gegenüber der Trägerschicht eine um einen Faktor 2, bevorzugt um einen Faktor 10, insbesondere bevorzugt um einen Faktor 100 geringere Absorption gegenüber der in Verfahrensschritt B1 und bevorzugt gegenüber der in Verfahrensschritt B2 verwendeten Laserstrahlung auf. Hierdurch ergibt sich der Vorteil eines verringerten Energieeintrags in die Strukturschicht durch die Laserstrahlung, sodass eine Ablation an der Grenzfläche zwischen Trägerschicht und Strukturschicht begünstigt wird.

Um zusätzlich Einflüsse durch etwaige Schädigungen der Schichtstruktur, insbesondere der Trägerschicht, durch die Laserstrahlung zu verringern, ist es vorteilhaft, dass nach Verfahrensschritt B1 ein Ausheilschritt erfolgt, mit einem Energieeintrag, bevorzugt einem Erwärmen, zumindest in den Bearbeitungsbereich B1, bevorzugt zumindest in die Bearbeitungsbereiche B1 und B2.

Durch den Energieeintrag in den oder die Bearbeitungsbereiche, insbesondere ein Erwärmen zumindest des oder der Bearbeitungsbereiche, bevorzugt der gesamten Schichtstruktur, kann in an sich bekannter Weise ein Ausheilen erfolgen, welches bei Halbleiterstrukturen dem Fachmann als Annealing bekannt ist.

Der Ausheilschritt erfolgt bevorzugt mittels lokalem Beaufschlagen der Schichtstruktur mit Laserstrahlung. Hierdurch ergibt sich der Vorteil, dass durch den Ausheilschritt Bereiche der Schichtstruktur außerhalb der Bearbeitungsbereiche nicht beeinträchtigt werden. Es konnte zusätzlich beobachtet werden, dass der nachgelagerte Ausheilschritt zur gänzlichen Öffnung von zuvor unvollständig ablatierten Bereich beitragen kann.

Vorteilhafterweise erfolgt in Verfahrensschritt B1 eine lokale Modifikation der Trägerschicht, insbesondere eine lokale Änderung der Kristallstruktur der Trägerschicht, bevorzugt eine Amorphisierung der Trägerschicht im Bearbeitungsbereich B1. Hierdurch wird in zuverlässiger Weise die Schwellfluenz im Bearbeitungsbereich B1 verringert.

Die lokale Modifikation der Trägerschicht im Bearbeitungsbereich B1 erfolgt bevorzugt mit einer Tiefe ausgehend von der Grenzfläche zwischen Trägerschicht und Strukturschicht von zumindest 10nm, insbesondere zumindest 20nm, bevorzugt zumindest 50nm. Hierdurch ist gewährleistet, dass in Teilschritt B2 eine Ablation aufgrund der in Teilschritt B1 verringerten Schwellfluenz erfolgt.

In Verfahrensschritt B1 und bevorzugt ebenso in Verfahrensschritt B2 wird in einer vorteilhaften Ausführungsform gepulste Laserstrahlung verwendet. Die Verwendung von gepulster Laserstrahlung weist den Vorteil auf, dass sie die notwendigen Temperaturgradienten induziert, welche für die lokale Modifikation erforderlich sind.

In einer vorteilhaften Weiterbildung weist die gepulste Laserstrahlung zumindest in Verfahrensschritt B1 eine Pulsdauer auf, die kleiner ist als 1ns, bevorzugt kleiner ist als 1ps.

Die vorstehend beschriebene Weiterbildung beruht auf der Erkenntnis, dass ein Laserpuls mit der genannten Pulsdauer in einfacher und zuverlässiger Weise zu einer irreversiblen Amorphisierung der Strukturschicht in dem ersten Bearbeitungsbereich B1 führen kann. Denn aufgrund der vergleichsweise kurzen Pulsdauer wird auch eine geringe Wärmemenge in die Strukturschicht, wenn diese in dem ersten Bearbeitungsbereich B1 mit Laserstrahlung beaufschlagt wird. Dadurch kann die Strukturschicht in dem ersten Bearbeitungsbereich, wie oben erwähnt, amorphisiert werden. Zudem gibt die Strukturschicht die zuvor eingebrachte Wärmemenge in sehr kurzer Abkühlzeit an ihre Umgebung ab, sodass der amorphisierte Bereich nicht rekristallisieren kann. Durch Erreichung einer irreversiblen Amorphisierung lässt sich die Schwellfluenz im ersten Bearbeitungsbereich B1 dauerhaft verringern.

Die Verwendung von gepulster Laserstrahlung ermöglicht in einer weiteren vorteilhaften Ausführungsform des erfindungsgemäßen Verfahrens die Verwendung gepulster Laserstrahlung aus einer gemeinsamen Laserquelle in den Verfahrensschritten B1 und B2. Es werden somit Laserpulse aus einer Laserquelle sowohl zur Beaufschlagung des ersten Bearbeitungsbereichs B1, als auch des zweiten Bearbeitungsbereiches B2 verwendet. Vorteilhafterweise sind hierbei die Fluenzen Φ_{L1} und Φ_{L2} identisch.

Vorteilhafterweise wird ein Laserpuls der Laserquelle mittels eines Strahlteilers in zumindest einen ersten und einen zweiten Laserpuls aufgeteilt und der erste Laserpuls wird für Verfahrensschritt B1 und der zweite Laserpuls für Verfahrensschritt B2 verwendet.

In einer vorteilhaften Weiterbildung des vorbeschriebenen Verfahrens wird ein Zeitversatz zwischen Auftreffen des ersten Laserpulses auf den ersten Bearbeitungsbereich B1 und Auftreffen des zweiten Laserpulses auf den zweiten Bearbeitungsbereich B2 erzielt, indem der zweite Laserpuls eine längere optische Wegstrecke durchläuft als der erste Laserpuls.

Hierdurch ergibt sich der Vorteil, dass durch einen kostengünstigen Aufbau mit lediglich einer Laserquelle das Verfahren durchführbar ist.

Die Vorrichtung zur Strukturierung einer Strukturschicht mittels Laserstrahlung weist eine Laserstrahlquelle zum Erzeugen eines gepulsten Ausgangsstrahls, einen im Strahlengang des Ausgangslaserstrahls angeordneten Strahlteiler zum Aufteilen des Ausgangslaserstrahls in zumindest einen ersten und einen zweiten Bearbeitungslaserstrahl auf.

Die Vorrichtung ist ausgebildet, einen ersten Bearbeitungsbereich B1 einer Strukturschicht mittels des ersten Bearbeitungslaserstrahls und einen zweiten Bearbeitungsbereich B2 der Strukturschicht mittels des zweiten Bearbeitungslaserstrahls zu beaufschlagen, wobei der zweite Bearbeitungsbereich B2 nur einen Teilbereich des ersten Bearbeitungsbereiches B1 überdeckt und die optische Weglänge des ersten Bearbeitungslaserstrahls kleiner ist als die optische Weglänge des zweiten Bearbeitungslaserstrahls. In einer vorteilhaften Weiterbildung weist die Vorrichtung ein optisches Element, insbesondere einen Strahlteil auf, welches ausgebildet ist, die Fluenzen der beiden optischen Strahlengänge in einem vorgegebenen Verhältnis aufzuteilen. In einer weiter vorteilhaften Weiterbildung ist zusätzlich ein Abschwächer der Vorrichtung als optisches Element in einem der Strahlengänge von erstem oder zweitem Bearbeitungslaserstrahl angeordnet, um die Intensität zu verringern.

Es ist daher vorteilhaft, dass sich die Laserleistung in beiden Strahlengängen unterscheidet.

Durch die Weglängendifferenz der optischen Weglängen des ersten und zweiten Bearbeitungslaserstrahls wird somit der Zeitversatz des Auftreffens der beiden Laserpulse erzielt. Die Weglängendifferenz liegt dabei bevorzugt im Bereich 1 cm bis 10 m, insbesondere bevorzugt im Bereich 1 m bis 10 m. Beispielsweise führt eine Weglängendifferenz von etwa 300 cm zu einer Zeitdifferenz zwischen Auftreffen des ersten und des zweiten Laserpulses von etwa 10 ns. Eine solche Zeitdifferenz ist für typische Laserpulse, welche typischerweise eine Pulslänge im Pico- oder Femtosekundenbereich haben, ausreichend.

Vorteilhafterweise wird eine Laserquelle verwendet, die Laserpulse mit einem Zeitabstand zwischen zwei Laserpulse aussendet, der größer als die vorgenannte Zeitdifferenz zwischen Auftreffen des ersten und des zweiten Laserpulses ist.

Vorteilhafterweise wird in Verfahrensschritt B1 und bevorzugt ebenso in Verfahrensschritt B2 Laserstrahlung im Wellenlängenbereich 200 nm bis 1100 nm, insbesondere 300 nm bis 600 nm verwendet. Hierdurch können an sich bekannte Apparaturen und Laser verwendet werden. Die vorgenannten bevorzugten Wellenlängenbereiche für die Laserstrahlung sind insbesondere vorteilhaft, bei Verwendung des Verfahrens zum Bearbeiten eines Halbleiterbauelementes, insbesondere einer Trägerschicht, welche eine Halbleiterschicht, insbesondere bevorzugt eine Siliziumschicht ist.

Bevorzugt wird in Verfahrensschritt B1 und weiter bevorzugt ebenso in Verfahrensschritt B2 Laserstrahlung mit einer Fluenz im Bereich 0.01 J/cm² bis 0.8 J/cm², insbesondere im Bereich 0.05 bis 0.2 J/cm² verwendet.

Laserstrahlung in einem solchen Fluenzbereich ist insbesondere zur Bearbeitung einer Schichtstruktur mit einer Siliziumschicht als Trägerschicht vorteilhaft.

Vorteilhaft ist eine Pulsdauer kleiner 1 ns, insbesondere kleiner 1 ps.

Es besteht auch Bedarf, die Linienbreite während des Prozesses variieren zu können, z.B. um keilförmige Linien zu erstellen, welche einen besseren Trade-Off zwischen Leitfähigkeit und Abschattung bieten. In einer vorteilhaften Ausführungsform wird daher der Bedeckungsgrad von erstem Bearbeitungsbereich B1 und zweitem Bearbeitungsbereich B2 variiert wird, um eine Linienbreite der erzeugten Strukturierung zu variieren.

Insbesondere ist es vorteilhaft, den Bedeckungsgrad kontinuierlich zu verkleinern oder zu vergrößern, um eine Strukturierung mit abnehmender oder zunehmender Breite zu erzielen.

Wie zuvor beschrieben, ist das erfindungsgemäße Verfahren insbesondere zur Bearbeitung einer Strukturschicht bei der Herstellung eines Halbleiterbauelementes, bevorzugt eines großflächigen Halbleiterbauelementes, insbesondere einer photovoltaischen Solarzelle geeignet.

Die Trägerschicht ist daher bevorzugt eine Halbleiterschicht, insbesondere bevorzugt eine Siliziumschicht und/oder ein Halbleiterwafer.

Die Strukturschicht kann als an sich bekannte Strukturschicht und/oder Maskierungsschicht ausgebildet sein. Für typische Anwendungen, insbesondere im Bereich der Photovoltaik, ist es vorteilhaft, dass die Strukturschicht eine dielektrische Schicht ist.

Es liegt im Rahmen der Erfindung, dass die Strukturschicht mittelbar unter Zwischenschaltung weiterer Schichten auf der Trägerschicht angeordnet ist. Um eine präzise Ablation der Strukturschicht zu erzielen, ist es vorteilhaft, dass die Strukturschicht unmittelbar auf der Trägerschicht angeordnet ist.

Das Schichtsystem wird bevorzugt zur Herstellung eines Halbleiterbauelementes, insbesondere einer photovoltaischen Solarzelle, verwendet. Insbesondere ist es vorteilhaft, dass die Strukturschicht als Maskierungsschicht zur Ausbildung einer selektiven Dotierung und/oder einer metallischen Kontaktierungsstruktur des Halbleiterbauelementes verwendet wird.

Weitere vorteilhafte Ausgestaltungen und vorteilhafte Merkmale werden im Folgenden anhand von Ausführungsbeispielen und den Figuren erläutert. Dabei zeigt:
- Figur 1: schematische Darstellungen von Teilschritten eines erfindungsgemäßen Verfahrens;
- Figur 2: Draufsichten auf sich überlappende Bearbeitungsbereiche und
- Figur 3: eine Vorrichtung, nicht Teil der Erfindung.

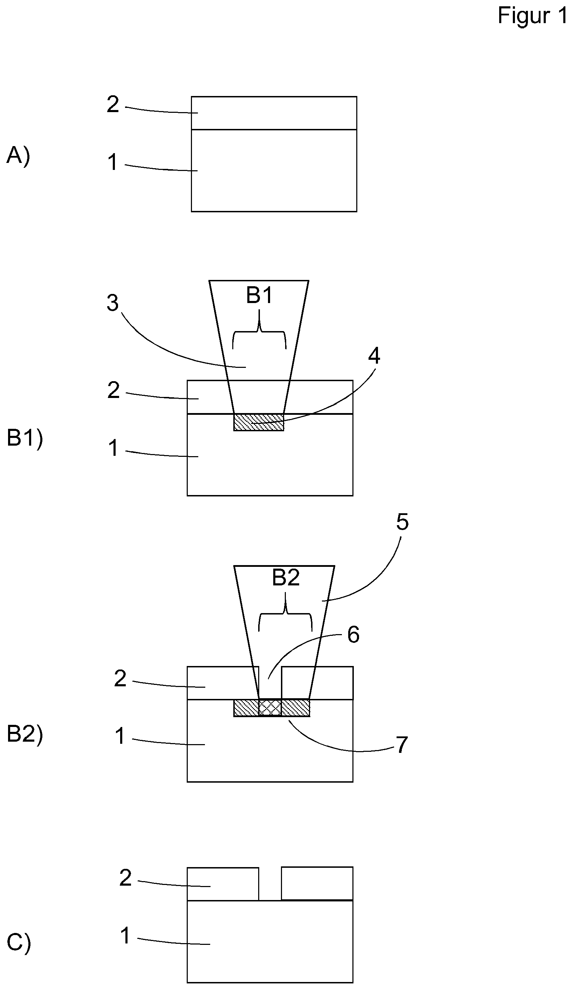

In Figur 1 sind schematisch Teilschritte eines Ausführungsbeispiels eines erfindungsgemäßen Verfahrens dargestellt. In einem Verfahrensschritt A erfolgt ein Bereitstellen einer Schichtstruktur mit einer Trägerschicht 1, welche als Siliziumwafer zur Herstellung einer photovoltaischen Solarzelle ausgebildet ist. Auf der Trägerschicht 1 ist unmittelbar eine als dielektrische Schicht, vorliegend als Siliziumoxidschicht mit einer Dicke von 100 nm ausgebildete Strukturschicht 2 angeordnet. Der Siliziumwafer weist eine Dicke von 150 µm auf.

Die Trägerschicht 1 weist an sich bekannte Dotierungen zum Ausbilden einer photovoltaischen Solarzelle auf, insbesondere einen an der oben liegenden Vorderseite angeordneten Emitter mit einer p-Dotierung sowie eine Basisdotierung des entgegengesetzten Dotierungstyps, eine n-Dotierung.

In einem Verfahrensschritt B erfolgt ein Beaufschlagen der Schichtstruktur mittels Laserstrahlung, um die Strukturschicht 2 in Teilbereichen zu entfernen.

Hierbei wird in einem Teilschritt B1 die Schichtstruktur mittels Laserstrahlung 3 in einem ersten Bearbeitungsbereich B1 mit einer ersten Fluenz Φ_{L1} der Laserstrahlung beaufschlagt.

Hierdurch wird in einem Modifizierungsbereich 4 die Schwellfluenz zur Ablation der Strukturschicht 2 verringert:
Vorliegend wird in Teilschritt B1 Laserstrahlung mit einer Wellenlänge von 515 nm, einer Pulsdauer von 180fs, einer Strahlqualität von M²<1.1, einem 1/e²-Strahldurchmesser 100µm im Fokus, Und einer ersten Fluenz Φ_{L1} = 0.1 J/cm² verwendet. Es ergibt sich ein Modifizierungsbereich in etwa mit der Breite des ersten Bearbeitungsbereiches B1 und vorliegend mit einer Tiefe von <1µm.

In dem Modifizierungsbereich ist die Schwellfluenz Φ_{S} der Schichtstruktur zur Ablation der Trägerschicht 1 von ursprünglich Φ_{S} = = 0.130 J/cm² abgesenkt auf eine verringerte Schwellfluenz Φ_{B1} von = 0.086 J/cm². Die in Teilschritt B1 verwendete erste Fluenz Φ_{L1} liegt somit unterhalb der Schwellfluenz Φ_{S}, sodass zwar eine Modifizierung des Modifizierungsbereiches 4 mit Absenken der Schwellfluenz Φ_{S} im Modifizierungsbereich 4 erfolgt, jedoch keine Ablation der Strukturschicht 2.

In einem Teilschritt B2 erfolgt ein Beaufschlagen der Schichtstruktur mittels Laserstrahlung 5 in einem zweiten Bearbeitungsbereich B2. Die Laserstrahlung 5 weist eine zweite Fluenz Φ_{L2} auf, welche größer als die verringerte Schwellfluenz Φ_{B1} im Modifizierungsbereich 4 und kleiner als die Schwellfluenz Φ_{S} ist.

Vorliegend weist die Laserstrahlung 5 folgende Parameter auf: Eine Wellenlänge von 515 nm, einer Pulsdauer von 180fs, einer Strahlqualität von M²<1.1, einem 1/e²-Strahldurchmesser 100µm im Fokus, und einer ersten Fluenz Φ_{L1} = 0.1 J/cm².

Da die zweite Fluenz Φ_{L2} größer als die verringerte Schwellfluenz Φ_{B1} ist, erfolgt in Teilschritt B2 eine Ablation der Strukturschicht 2 im Ablationsbereich 6. Der Ablationsbereich 6 entspricht in etwa dem Bereich, in welchem der Bearbeitungsbereich B2 den Bearbeitungsbereich B1 überdeckt. Vorliegend überdeckt der zweite Bearbeitungsbereich B2 einen Teilbereich des ersten Bearbeitungsbereiches B1, welcher etwa 40 % der Fläche des Bearbeitungsbereiches B1 entspricht. Auch die Beaufschlagung mit Laserstrahlung in Teilschritt B2 führt zu einer Modifizierung der Strukturschicht in einem zweiten Modifizierungsbereich 7. Insbesondere im Überlappungsbereich vom ersten Modifizierungsbereich 4 und zweiten Modifizierungsbereich 7 und somit im Überlappungsbereich zwischen ersten Bearbeitungsbereich B1 und zweiten Bearbeitungsbereich B2 erfolgt eine stärkere Modifizierung der Strukturschicht 2.

Aus diesem Grund erfolgt in Verfahrensschritt C ein Annealing, in dem die Schichtstruktur auf eine Temperatur im Bereich von 500 °C bis 1000 °C, vorliegend 900°C für eine Zeitdauer im Bereich von 1h bis 5 Minuten, vorliegend 10 Minuten erwärmt wird, um die Modifizierung in den Modifizierungsbereichen 4 und 7 auszuheilen.

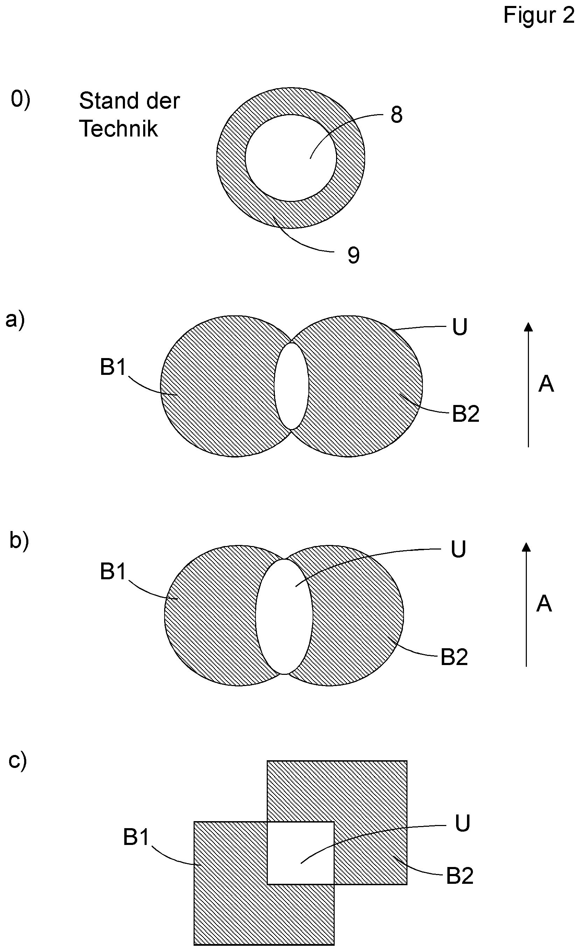

In Figur 2 sind verschiedene Ausgestaltungen von Bearbeitungsbereichen B1 und B2 jeweils in Draufsicht von oben dargestellt.

Zunächst ist im oberen Bereich der Figur 2 die Verwendung von Laserstrahlung zur Ablation einer Strukturschicht nach dem Stand der Technik dargestellt: Demgemäß wird mit Laserstrahlung, welche typischerweise einen kreisförmigen Durchmesser aufweist, die Schichtstruktur beaufschlagt. Die Laserstrahlung 8 nach dem Stand der Technik weist eine Fluenz auf, welche größer als die Schwellfluenz der Schichtstruktur ist, sodass in dem kreisförmigen Bereich 8 eine Ablation der Strukturschicht erfolgt. Typischerweise weist die Intensität der Laserstrahlung eine Gauss-Form auf. Dementsprechend erfolgt in einem gestrichelt dargestellten kreisringförmigen Randbereich keine Ablation der Strukturschicht, da hier die Intensität und Fluenz der Laserstrahlung unterhalb der Schwellfluenz liegt, jedoch eine zumindest geringfügige Modifikation der Trägerschicht. Dieser Modifizierungsbereich 9 liegt somit in einem Bereich, in welchem die Strukturschicht nicht entfernt wird.

In den Teilbildern a bis c sind verschiedene Formen von Bearbeitungsbereichen B1 und B2 dargestellt, wobei gemäß der Ausgestaltungen a und b Laserstrahlung mit kreisförmigem Querschnitt verwendet wird, gemäß der Ausgestaltung in Teilbild c Laserstrahlung mit quadratischem Querschnitt. Entsprechend sind die jeweils nicht schraffierten Überlappungsbereiche ausgebildet, in welchen eine Ablation der Trägerschicht 1 erfolgt. Die Teilbilder a und b unterscheiden sich, indem in Teilbild b eine größere Überlappung U der Bearbeitungsbereiche B1 und B2 vorliegt und somit in einem größeren Bereich eine Ablation der Trägerschicht erfolgt.

Werden nun mehrere Bearbeitungen mit versetzten Bearbeitungsbereichen B1 und B2 vorgenommen, insbesondere entlang der Richtung A in Figur 2a oder 2b, so können aneinandergrenzende oder auch überlappende Ablationsbereiche erzeugt und so beispielsweise linienartige, insbesondere zumindest annähernd geradlinige Öffnungen mittels Ablation der Strukturschicht erzeugt werden. In einer Weiterbildung wird der Überdeckungsgrad zwischen Bearbeitungsbereich B1 und B2 variiert, vorliegend kontinuierlich verkleinert, so dass eine linienartige Öffnung der Strukturschicht mit abnehmender Breite erzeugt wird. Ebenso kann durch kontinuierliche Zunahme des Bedeckungsgrades eine linienartige Öffnung der Strukturschicht mit zunehmende Breite erzeugt werden.

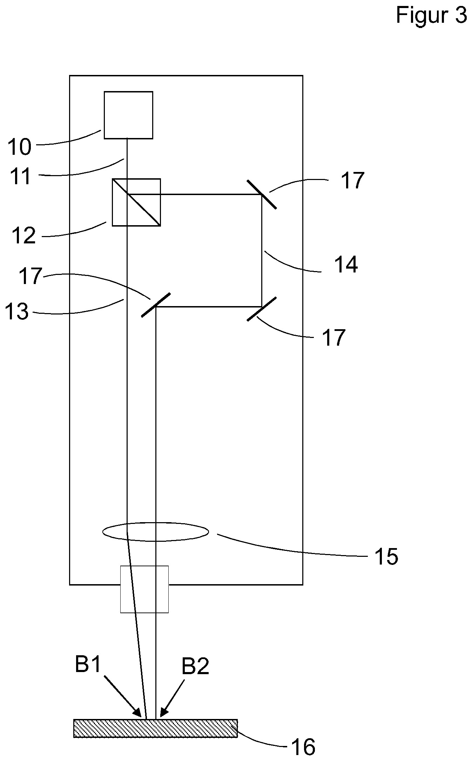

In Figur 3 ist eine Vorrichtung zur Strukturierung einer Strukturschicht mittels Laserstrahlung dargestellt. Die Vorrichtung weist eine Laserstrahlquelle 10 auf, welche vorliegend als Festkörper-Laser ausgebildet ist, um einen Ausgangslaserstrahl 11 zu erzeugen, der aus Laserpulsen der Wellenlänge 515nm mit einer Pulslänge von 180 fs besteht.

Mittels eines Strahlteilers 12 der Vorrichtung wird der Ausgangstrahl 11 in einen ersten Bearbeitungslaserstrahl 13 und einen zweiten Bearbeitungslaserstrahl 14 aufgeteilt. Die Aufteilung erfolgt mit identischen Intensitäten, sodass die Laserpulse des ersten Bearbeitungslaserstrahls und des zweiten Bearbeitungslaserstrahls in etwa die gleichen Laserparameter aufweisen.

Der erste Bearbeitungsstrahl 13 wird über eine optische Linse 15 auf einen Bearbeitungsbereich B1 eines Substrats 16, welches Trägerschicht 1 und Strukturschicht 2 aufweist, abgebildet. Der zweite Bearbeitungslaserstrahl 14 wird über drei optische Spiegel 17 umgelenkt und ebenfalls über die optische Linse 15 auf einen Bearbeitungsbereich B2 des Substrats 16 abgebildet.

In der Darstellung gemäß Figur 3 sind die Laserstrahlen 11, 13 und 14 zur besseren Darstellbarkeit lediglich als dünne Linien dargestellt. Tatsächlich überlappen sich auf der Oberfläche des Substrats 16 erster Bearbeitungslaserstrahl 13 und zweiter Bearbeitungslaserstrahl 14, sodass in Draufsicht eine teilweise Überlappung gemäß Figur 2a) besteht.

Aufgrund der Umlenkung über die drei Spiegel 17 ist die optische Weglänge zwischen Strahlteiler 12 und Substrat 16 des zweiten Bearbeitungslaserstrahls 14 größer als die des ersten Bearbeitungslaserstrahls 13 zwischen Strahlteiler 12 und Substrat 16. Die Differenz der optischen Weglänge beträgt etwa 300 cm, sodass der Laserpuls im Bearbeitungsbereich B2 etwa 10 ns später auf das Substrat 16 auftrifft, als der Laserpuls im Bearbeitungsbereich B1.

Die Laserstrahlquelle 10 ist ausgebildet, Laserpulse mit einem größeren Zeitabstand als die Zeitdifferenz des Auftreffens der Laserpulse auszusenden. Vorliegend werden Laserpulse von der Laserstrahlquelle 10 mit einem Zeitabstand von 5 ns ausgesandt.

### Bezugszeichenliste

- 1: Trägerschicht
- 2: Strukturschicht
- 3: Laserstrahlung der Fluenz Φ_{L1}
- 4: erster Modifizierungsbereich
- 5: Laserstrahlung der Fluenz Φ_{L2}
- 6: Ablationsbereich
- 7: zweiter Modifizierungsbereich
- 8: Laserstrahlung Stand der Technik
- 9: Modifizierungsbereich Stand der Technik
- 10: Laserstrahlquelle
- 11: Ausgangslaserstrahl
- 12: Strahlteiler
- 13: erster Bearbeitungslaserstrahl
- 14: zweiter Bearbeitungslaserstrahl
- 15: optische Linse
- 16: Substrat
- 17: optische Spiegel

- B1: erster Bearbeitungsbereich
- B2: zweiter Bearbeitungsbereich
- U: Überlappung

## Patentansprüche

1. Verfahren zur Strukturierung einer Strukturschicht (2) mittels Laserstrahlung, mit den Verfahrensschritten
A. Bereitstellen einer Schichtstruktur mit zumindest einer Trägerschicht und zumindest einer auf der Trägerschicht angeordneten Strukturschicht (2) und
B. Beaufschlagen der Schichtstruktur mittels Laserstrahlung, um die Strukturschicht (2) in Teilbereichen zu entfernen;
wobei in Verfahrensschritt B
in einem Teilschritt B1 ein Beaufschlagen der Schichtstruktur mittels Laserstrahlung in einem ersten Bearbeitungsbereich B1 mit einer ersten Fluenz Φ_{L1} der Laserstrahlung erfolgt, sodass in dem mittels Laserstrahlung beaufschlagten ersten Bearbeitungsbereich B1 eine Schwellfluenz Φ_{S} des Schichtsystems zur Ablation der Strukturschicht (2) auf eine verringerte Schwellfluenz Φ_{B1} < Φ_{S} abgesenkt wird, wobei die erste Fluenz Φ_{L1} unterhalb der Schwellfluenz Φ_{S} des Schichtsystems liegt und
in einem Teilschritt B2 ein Beaufschlagen der Schichtstruktur mittels Laserstrahlung in einem zweiten Bearbeitungsbereich B2 mit einer zweiten Fluenz Φ_{L2} erfolgt,
**dadurch gekennzeichnet, dass**
die zweite Fluenz Φ_{L2} größer als die verringerte Schwellfluenz Φ_{B1} des ersten Bearbeitungsbereiches B1 und kleiner als die Schwellfluenz Φ_{S}, und dass der zweite Bearbeitungsbereich B2 nur einen Teilbereich des ersten Bearbeitungsbereiches B1 überdeckt.

2. Verfahren nach Anspruch 1,
**dadurch gekennzeichnet,**
**dass** der zweite Bearbeitungsbereich B2 weniger als 50%, insbesondere weniger als 20% der Fläche des ersten Bearbeitungsbereichs B1 überdeckt, insbesondere, dass der zweite Bearbeitungsbereich B2 im Bereich 1% bis 50%, insbesondere 5% bis 20% der Fläche des ersten Bearbeitungsbereiches B1 überdeckt.

3. Verfahren nach einem der vorangegangenen Ansprüche,
**dadurch gekennzeichnet,**
**dass** die Strukturschicht (2) gegenüber der Trägerschicht eine um einen Faktor 2, bevorzugt um einen Faktor 10, insbesondere bevorzugt um einen Faktor 100 geringere Absorption gegenüber der in Verfahrensschritt B1 und bevorzugt gegenüber der in Verfahrensschritt B2 verwendeten Laserstrahlung aufweist.

4. Verfahren nach einem der vorangegangenen Ansprüche,
**dadurch gekennzeichnet,**
**dass** nach Verfahrensschritt B1 ein Ausheilschritt erfolgt, mit einem Energieeintrag, bevorzugt ein Erwärmen zumindest in den Bearbeitungsbereich B1, bevorzugt zumindest in die Bearbeitungsbereiche B1 und B2, und insbesondere, dass der Ausheilschritt zwischen den Verfahrensschritten B1 und B2 erfolgt, vorzugsweise, dass der Ausheilschritt mittels lokalem Beaufschlagen der Schichtstruktur mit Laserstrahlung erfolgt.

5. Verfahren nach einem der vorangegangenen Ansprüche,
**dadurch gekennzeichnet,**
**dass** in Verfahrensschritt B1 eine lokale Modifikation der Trägerschicht, insbesondere eine lokale Änderung einer Kristallstruktur der Trägerschicht, bevorzugt eine Amorphisierung der Trägerschicht im Bearbeitungsbereich B1 erfolgt, insbesondere,
**dass** die lokale Modifikation der Trägerschicht im Bearbeitungsbereich B1 eine Tiefe von zumindest 5nm, insbesondere zumindest 10nm, bevorzugt zumindest 100nm aufweist.

6. Verfahren nach einem der vorangegangenen Ansprüche,
**dadurch gekennzeichnet,**
**dass** in Verfahrensschritt B1 und bevorzugt in Verfahrensschritt B2 gepulste Laserstrahlung verwendet wird, wobei insbesondere die gepulste Laserleistung zumindest in Verfahrensschritt B1 eine Pulsdauer aufweist, die kleiner ist als 1ns, bevorzugt kleiner ist als 1ps.

7. Verfahren nach Anspruch 6,
**dadurch gekennzeichnet,**
**dass** in Verfahrensschritt B1 und B2 gepulste Laserstrahlung aus einer gemeinsamen Laserquelle verwendet wird, wobei ein Laserpuls der Laserquelle mittels eines Strahlteilers in zumindest einen ersten und einen zweiten Laserpuls aufgeteilt wird und der erste Laserpuls für Verfahrensschritt B1 und der zweite Laserpuls für Verfahrensschritt B2 verwendet wird, insbesondere dass ein Zeitversatz zwischen Auftreffen des ersten Laserpulses auf den ersten Bearbeitungsbereich B1 und Auftreffen des zweiten Laserpulses auf den zweiten Bearbeitungsbereich B2 erzielt wird, indem der zweite Laserpuls eine längere optische Wegstrecke durchläuft als der erste Laserpuls und bevorzugt, dass sich die Laserleistung in beiden Strahlengängen unterscheidet.

8. Verfahren nach einem der vorangegangenen Ansprüche,
**dadurch gekennzeichnet,**
**dass** in Verfahrensschritt B1 und bevorzugt in Verfahrensschritt B2 Laserstrahlung im Wellenlängenbereich 200 nm bis 1100nm, insbesondere 300 nm bis 600 nm verwendet wird.

9. Verfahren nach einem der vorangegangenen Ansprüche,
**dadurch gekennzeichnet,**
**dass** in Verfahrensschritt B1 und bevorzugt in Verfahrensschritt B2 Laserstrahlung mit einer Fluenz im Bereich 0.01 bis 0.8 J/cm², insbesondere im Bereich 0.05 bis 0.2 J/cm²verwendet wird.

10. Verfahren nach einem der vorangegangenen Ansprüche,
**dadurch gekennzeichnet,**
**dass** die Trägerschicht eine Halbleiterschicht ist, insbesondere eine Siliziumschicht und/oder ein Halbleiterwafer und/oder
**dass** die Strukturschicht (2) eine dielektrische Schicht ist.

11. Verfahren nach einem der vorangegangenen Ansprüche,
**dadurch gekennzeichnet,**
**dass** Strukturschicht (2) unmittelbar auf Trägerschicht angeordnet ist.

12. Verfahren nach einem der vorangegangenen Ansprüche,
**dadurch gekennzeichnet,**
**dass** das Schichtsystem zur Herstellung eines Halbleiterbauelementes, insbesondere einer photovoltaischen Solarzelle verwendet wird,
bevorzugt, dass die Strukturschicht (2) als Maskierungsschicht zur Ausbildung einer selektiven Dotierung und/oder einer metallischen Kontaktierungsstruktur des Halbleiterbauelementes verwendet wird.

13. Verfahren nach einem der vorangegangenen Ansprüche,
**dadurch gekennzeichnet,**
**dass** der Bedeckungsgrad von erstem Bearbeitungsbereich B1 und zweitem Bearbeitungsbereich B2 variiert wird, um eine Linienbreite der erzeugten Strukturierung zu variieren.

14. Verfahren nach einem der vorangegangenen Ansprüche,
**dadurch gekennzeichnet,**
**dass** der erste Bearbeitungsbereich B2 nur einen Teilbereich des zweiten Bearbeitungsbereiches B1 überdeckt.

## Claims

1. Method for structuring a structural layer (2) by means of laser radiation, with the method steps of
A. Providing a layer structure with at least one substrate layer and at least one structural layer (2) arranged on the substrate layer and
B. Applying laser radiation to the layer structure, in order to remove the structural layer (2) in sections,
wherein in method step B
in one sub-step B1, laser radiation is applied to the layer structure in a first processing region B1 with a first fluence Φ_{L1} of the laser radiation, such that, in the first processing region B1 to which laser radiation is applied, a threshold fluence Φ_{S} of the layer system is lowered to a reduced threshold fluence Φ_{B1} < Φ_{S} for ablation of the structural layer (2), wherein the first fluence Φ_{L1} is below the threshold fluence Φ_{S} of the layer system and
in one sub-step B2, laser radiation is applied to the layer structure in a second processing region B2 with a second fluence Φ_{L2},
**characterized in that**
the second fluence Φ_{L2} is greater than the reduced threshold fluence Φ_{B1} of the first processing region B1 and lower than the threshold fluence Φ_{S}, and **in that** the second processing region B2 only covers a section of the first processing region B1.

2. Method according to claim 1,
**characterized in that**
the second processing region B2 covers less than 50%, in particular less than 20% of the area of the first processing region B1, in particular, **in that** the second processing region B2 covers in the range of 1% to 50%, in particular 5% to 20%, of the area of the first processing region B1.

3. Method according to any one of the preceding claims,
**characterized in that**
the structural layer (2) has a lower absorption by a factor of 2, preferably by a factor of 10, particularly preferably by a factor of 100, relative to the substrate layer compared to the laser radiation used in method step B1 and preferably compared to the laser radiation used in method step B2.

4. Method according to any one of the preceding claims,
**characterized in that**
an annealing step takes place after method step B1, with an energy input, preferably heating, at least in the processing region B1, preferably at least in the processing regions B1 and B2, and in particular, **in that** the annealing step takes place between the method steps B1 and B2, preferably, **in that** the annealing step is performed by means of local application of laser radiation to the layer structure.

5. Method according to any one of the preceding claims,
**characterized in that**
in method step B1, a local modification of the substrate layer, in particular a local change to a crystal structure of the substrate layer, preferably an amorphisation of the substrate layer, takes place in the processing region B1, in particular, **in that** the local modification of the substrate layer in the processing region B1 has a depth of at least 5nm, in particular at least 10nm, preferably at least 100nm.

6. Method according to any one of the preceding claims,
**characterized in that**
pulsed laser radiation is used in method step B1 and preferably in method step B2, wherein, in particular, the pulsed laser output has a pulse duration, at least in method step B1, which is less than 1ns, preferably less than 1ps.

7. Method according to claim 6,
**characterized in that**
in method step B1 and B2, pulsed laser radiation from a common laser source is used, wherein a laser pulse of the laser source is divided into at least a first and a second laser pulse by means of a beam splitter and the first laser pulse is used for method step B1 and the second laser pulse is used for method step B2, in particular **in that** a time delay between the impact of the first laser pulse on the first processing region B1 and the impact of the second laser pulse on the second processing region B2 is achieved by the second laser pulse passing through a longer optical path than the first laser pulse and preferably, **in that** the laser output differs in both beam paths.

8. Method according to any one of the preceding claims,
**characterized in that**
in method step B1 and preferably in method step B2, laser radiation in the wavelength range of 200 nm to 1100nm, in particular 300 nm to 600 nm, is used.

9. Method according to any one of the preceding claims,
**characterized in that**
in method step B1 and preferably in method step B2, laser radiation with a fluence in the range of 0.01 to 0.8 J/cm², in particular in the range of 0.05 to 0.2 J/cm², is used.

10. Method according to any one of the preceding claims,
**characterized in that**
the substrate layer is a semiconductor layer, in particular a silicon layer and/or a semiconductor wafer and/or
**in that** the structural layer (2) is a dielectric layer.

11. Method according to any one of the preceding claims,
**characterized in that**
the structural layer (2) is arranged directly on the substrate layer.

12. Method according to any one of the preceding claims,
**characterized in that**
the layer system is used to produce a semiconductor component, in particular a photovoltaic solar cell, preferably, **in that** the structural layer (2) is used as a masking layer for creating a selective doping and/or a metallic contacting structure of the semiconductor component.

13. Method according to any one of the preceding claims,
**characterized in that**
the degree of coverage of the first processing region B1 and the second region B2 is varied, in order to vary a line width of the structuring produced.

14. Method according to any one of the preceding claims,
**characterized in that**
the first processing region B2 only covers a section of the second processing region B1.

## Revendications

1. Procédé de structuration d'une couche structurelle (2) par rayonnement laser, avec les étapes de procédé suivantes
A. la fourniture d'une structure de couches avec au moins une couche porteuse et au moins une couche structurelle (2) agencée sur la couche porteuse et
B. la sollicitation de la structure de couches par rayonnement laser afin de retirer la couche structurelle (2) dans des zones partielles ;
dans lequel dans l'étape de procédé B
dans une étape partielle B1, une sollicitation de la structure de couches est effectuée par rayonnement laser dans une première zone d'usinage B1 avec une première fluence Φ_{L1} du rayonnement laser, de sorte que dans la première zone d'usinage B1 sollicitée par rayonnement laser, une fluence seuil Φ_{S} du système de couches pour l'ablation de la couche structurelle (2) soit abaissée à une fluence seuil réduite Φ_{B1} < Φ_{S}, dans lequel la première fluence Φ_{L1} est en dessous de la fluence seuil Φ_{S} du système de couches et
dans une étape partielle B2, une sollicitation de la structure de couches est effectuée par rayonnement laser dans une seconde zone d'usinage B2 avec une seconde fluence Φ_{L2},
**caractérisé en ce que**
la seconde fluence Φ_{L2} est supérieure à la fluence seuil réduite Φ_{B1} de la première zone d'usinage B1 et inférieure à la fluence seuil Φ_{S}, et **en ce que** la seconde zone d'usinage B2 ne recouvre qu'une zone partielle de la première zone d'usinage B1.

2. Procédé selon la revendication 1,
**caractérisé en ce que**
la seconde zone d'usinage B2 recouvre moins de 50 %, en particulier moins de 20 % de la surface de la première zone d'usinage B1, en particulier **en ce que** la seconde zone d'usinage B2 recouvre dans la plage de 1 % à 50 %, en particulier de 5 % à 20 % de la surface de la première zone d'usinage B1.

3. Procédé selon l'une quelconque des revendications précédentes,
**caractérisé en ce que**
la couche structurelle (2) présente par rapport à la couche porteuse une absorption plus faible d'un facteur 2, de préférence d'un facteur 10, en particulier de préférence d'un facteur 100 par rapport au rayonnement laser utilisé dans l'étape de procédé B1 et de préférence par rapport au rayonnement laser utilisé dans l'étape de procédé B2.

4. Procédé selon l'une quelconque des revendications précédentes,
**caractérisé en ce que**
après l'étape de procédé B1, une étape de recuit est effectuée avec un apport d'énergie, de préférence un chauffage au moins dans la zone d'usinage B1, de préférence au moins dans les zones d'usinage B1 et B2, et en particulier **en ce que** l'étape de recuit est effectuée entre les étapes de procédé B1 et B2, de préférence **en ce que** l'étape de recuit est effectuée par sollicitation locale de la structure de couches avec un rayonnement laser.

5. Procédé selon l'une quelconque des revendications précédentes,
**caractérisé en ce que**
dans l'étape de procédé B1, une modification locale de la couche porteuse, en particulier un changement local d'une structure cristalline de la couche porteuse, de préférence une amorphisation de la couche porteuse est effectuée dans la zone d'usinage B1, en particulier **en ce que** la modification locale de la couche porteuse dans la zone d'usinage B1 présente une profondeur d'au moins 5 nm, en particulier d'au moins 10 nm, de préférence d'au moins 100 nm.

6. Procédé selon l'une quelconque des revendications précédentes,
**caractérisé en ce que**
dans l'étape de procédé B1 et de préférence dans l'étape de procédé B2, un rayonnement laser pulsé est utilisé, dans lequel en particulier la puissance laser pulsée au moins dans l'étape de procédé B1 présente une durée de pulsation qui est inférieure à 1 ns, de préférence inférieure à 1 ps.

7. Procédé selon la revendication 6,
**caractérisé en ce que**
dans les étapes de procédé B1 et B2, un rayonnement laser pulsé d'une source laser commune est utilisé, dans lequel une pulsation laser de la source laser est répartie au moyen d'un séparateur de faisceaux en au moins une première et une seconde pulsation laser, et la première pulsation laser est utilisée pour l'étape de procédé B1 et la seconde pulsation laser est utilisée pour l'étape de procédé B2, en particulier **en ce qu'**un décalage temporel est obtenu entre l'impact de la première pulsation laser sur la première zone d'usinage B1 et l'impact de la seconde pulsation laser sur la seconde zone d'usinage B2, **en ce que** la seconde pulsation laser parcourt un trajet optique plus long que la première pulsation laser et de préférence **en ce que** la puissance laser diffère dans les deux trajectoires de faisceau.

8. Procédé selon l'une quelconque des revendications précédentes,
**caractérisé en ce que**
dans l'étape de procédé B1 et de préférence dans l'étape de procédé B2, un rayonnement laser est utilisé dans la plage de longueur d'ondes 200 nm à 1100 nm, en particulier 300 nm à 600 nm.

9. Procédé selon l'une quelconque des revendications précédentes,
**caractérisé en ce que**
dans l'étape de procédé B1 et de préférence dans l'étape de procédé B2, un rayonnement laser est utilisé avec une fluence dans la plage de 0,01 à 0,8 J/cm², en particulier dans la plage de 0,05 à 0,2 J/cm².

10. Procédé selon l'une quelconque des revendications précédentes,
**caractérisé en ce que**
la couche porteuse est une couche semi-conductrice, en particulier une couche de silicium et/ou une tranche de semi-conducteur et/ou
la couche structurelle (2) est une couche diélectrique.

11. Procédé selon l'une quelconque des revendications précédentes,
**caractérisé en ce que**
la couche structurelle (2) est agencée directement sur la couche porteuse.

12. Procédé selon l'une quelconque des revendications précédentes,
**caractérisé en ce que**
le système de couches est utilisé pour la fabrication d'un composant semi-conducteur, en particulier une cellule solaire photovoltaïque, de préférence **en ce que** la couche structurelle (2) est utilisée comme couche de masquage pour la formation d'une dotation sélective et/ou d'une structure de mise en contact métallique du composant semi-conducteur.

13. Procédé selon l'une quelconque des revendications précédentes,
**caractérisé en ce que**
le degré de couverture de la première zone d'usinage B1 et de la seconde zone d'usinage B2 est varié afin de faire varier une largeur de ligne de la structuration générée.

14. Procédé selon l'une quelconque des revendications précédentes,
**caractérisé en ce que**
la première zone d'usinage B2 ne recouvre qu'une zone partielle de la seconde zone d'usinage B1.
